# EUROPEAN PATENT APPLICATION

(11) **EP 3 503 208 A1**
(43) Date of publication of application: **26.06.2019**
(21) Application number: 18183592.7
(22) Date of filing: 16.07.2018
(51) Int. Cl.: H01L 31/0216, H01L 31/0224, H01L 31/0747, H01L 31/18

(54) **THIN FILM ASSEMBLY AND METHOD OF PREPARING THE SAME, AND HETERO-JUNCTION SOLAR CELL INCLUDING THIN FILM ASSEMBLY**

(30) Priority: 21.12.2017 CN 201711395346; 21.12.2017 CN 201721807096 U
(71) Applicant: Beijing Juntai Innovation Technology Co., Ltd, 100176 Beijing (CN)
(72) Inventor: CUI, Ge, BEIJING, Beijing 100176 (CN); HE, Yongcai, BEIJING, Beijing 100176 (CN); YU, Cao, BEIJING, Beijing 100176 (CN); ZHANG, Jinyan, BEIJING, Beijing 100176 (CN); XU, Xixiang, BEIJING, Beijing 100176 (CN)
(74) Representative: Peguet, Wilfried

(57) **Abstract**

The present disclosure provides a thin film assembly (5,5') and a method of preparing the same, and a hetero-junction cell including a thin film assembly (5,5'). The thin film assembly (5,5') comprises at least two transparent conductive oxide film layers superposed together, each of the at least two transparent conductive oxide film layers is an ITO film, the first ITO film layer (5-1,5-1') is doped with a tin content of 10-15 wt%, and the second ITO film layer (5-2,5-2') is doped with a tin content ≥ 5 wt% and <10 wt%.

## Description

### CROSS-REFERENCE TO RELATED APPLICATION

This application claims the priority of Chinese Patent Applications No. 201711395346.6 and No. 201721807096.8 submitted to the Chinese Intellectual Property Office on December 21, 2017, the disclosure of both are incorporated herein in its entirety by reference.

### TECHNICAL FIELD

This disclosure relates to the technical field of solar cell technology, and particularly relates to a thin film assembly and a method of preparing the same, and a hetero-junction cell including a thin film assembly.

### BACKGROUND OF THE INVENTION

Due to low resistivity, high visible light transmittance and other good physical properties, Indium Tin Oxide (ITO) film is widely applied into transparent conductive oxide film layers for Hetero-junction with Intrinsic Thin layer solar cells (also referred to as hetero-junction cells or HIT or HJT cells for short).

ITO film serves as a conductive and antireflective film in HJT cells. The current widely used ITO films are all single-layer films. As an antireflective film, the conventional ITO single-layer film of 1/4 wavelength has a good antireflection effect only at a small-angle incidence of a specific wavelength. As a result, this single-layer film cannot fully satisfy the antireflective requirements of light for HJT cells within a greater wavelength range and at greater incident angles.

### SUMMARY

The present disclosure has been accomplished in order to at least partially solve the problems in the prior art. The present disclosure provides an HJT cell with improved performance and a thin film assembly for realizing improved performance of an HJT cell and a method of preparing the thin film assembly.

According to one aspect of the disclosure, there is provided a thin film assembly comprising at least two transparent conductive oxide film layers superposed together, each of the at least two transparent conductive oxide film layers being an ITO film, the first ITO film layer is doped with a tin content of 10-15 wt%, and the second ITO film layer is doped with a tin content ≥ 5 wt% and <10 wt%.

The thin film assembly may also include a third ITO film layer doped with a tin content ≥ 1 wt% and <5 wt%, or of 10-15 wt%, the first, second and third ITO film layers being arranged sequentially.

The first ITO film layer may be doped with a tin content of 10 wt%, the second ITO film layer may be doped with a tin content of 5 wt%, and the third ITO film layer may be doped with a tin content of 3 wt%.

The thin film assembly may also include a fourth ITO film layer doped with a tin content of 10-15 wt%, the first, second, third and fourth ITO film layers being arranged sequentially.

The first ITO film layer may be doped with a tin content of 10 wt%, the second ITO film layer may be doped with a tin content of 5 wt%, the third ITO film layer may be doped with a tin content of 3 wt%, and the fourth ITO film layer may be doped with a tin content of 10 wt%.

Each of the ITO film layers may have a thickness in a range of 10-50 nm.

Each of the ITO film layers may have a refractive index n in a range of 1.8-2.0, a band gap in a range of 3.0-4.6 eV, a carrier concentration in a range of (1-10) × 10²⁰ cm⁻³, and a carrier mobility in a range of 10-50 cm²/vs.

According to another aspect of the disclosure, there is provided a method of preparing the above discussed thin film assembly, comprising: preparing a plurality of ITO film layers continuously under vacuum.

The step of preparing a plurality of ITO film layers continuously under vacuum may include: preparing a plurality of ITO film layers continuously under vacuum by magnetron sputtering, where a gas used in the magnetron sputtering is a mixture of oxygen and argon, a volumetric flow rate ratio of the oxygen to the argon is 0-2:98, a sputtering power is 2-8kW, and a base pressure in a chamber used in the preparation is controlled in a range of ≥ 5 × 10⁻⁴ Pa.

According to another aspect of the disclosure, there is provided a hetero-junction cell including the above discussed thin film assembly.

The hetero-junction cell may include a first thin film assembly composed of at least three ITO film layers superposed together at one side thereof and a second thin film assembly composed of at least two ITO film layers superposed together at the other side thereof.

The hetero-junction cell may also include a crystalline silicon layer having a first surface and a second surface facing away from each other, a first intrinsic layer, a second intrinsic layer, a first doping layer, a second doping layer, a first grid line and a second grid line;
the first thin film assembly is provided with four ITO film layers, and the second thin film assembly is provide with three ITO film layers;
the first intrinsic layer, the first doping layer, a fourth ITO film layer , a third ITO film layer, a second ITO film layer and a first ITO film layer of the first thin film assembly, and the first grid line may be provided on the first surface of the crystalline silicon layer from inside to outside sequentially;
the second intrinsic layer, the second doping layer, a third ITO film layer, a second ITO film layer and a first ITO film layer of the second thin film assembly, and the second grid line may be provided on the second surface of the crystalline silicon layer from inside to outside sequentially.

The first ITO film layer of the first thin film assembly may be doped with a tin content of 10 wt%, the second ITO film layer of the first thin film assembly may be doped with a tin content of 5 wt%, the third ITO film layer of the first thin film assembly may be doped with a tin content of 3 wt%, and the fourth ITO film layer of the first thin film assembly may be doped with a tin content of 10 wt%;

The first ITO film layer of the second thin film assembly may be doped with a tin content of 10 wt%, the second ITO film layer of the second thin film assembly may be doped with a tin content of 5 wt%, and the third ITO film layer of the second thin film assembly may be doped with a tin content of 3 wt%.

The crystalline silicon layer may be an n-type crystalline silicon layer or a p-type crystalline silicon layer; and
the first doping layer may be an n-type doping layer, while the second doping layer may be a p-type doping layer.

A work function of the third ITO film layer of the second thin film assembly in contact with the second doping layer may be greater than a work function of the fourth layer ITO film layer of the first thin film assembly in contact with the first doping layer.

The applicant of the present disclosure has found that photoelectric properties of the ITO film, such as the refractive index, the work function and the matching of the p-type doping layer and the n-type doping layer, directly affect performance of the HJT cell. The present disclosure provides a thin film assembly including a plurality of ITO film layers, which forms a multi-layer stepped ITO antireflective film by gradually changing the tin content doped in each of the ITO film layers, thus improving photoelectric properties of the thin film assembly. Specifically, compared with a single-layer ITO film, an advantage of the multi-layer stepped ITO antireflective film of the present disclosure is further reducing light loss through the multi-layer stepped ITO structure, and at the same time, by optimizing the work function matching between the ITO film and the p-type and n-type doping layers, enabling the ITO in contact with the n-type doping layer a lower work function and the ITO in contact with the p-type doping layer a higher work function, thereby improving various performance indicators of the HJT cell.

### BRIEF DESCRIPTION OF THE FIGURES

Accompanying drawings are provided for further understanding of the technical solution of the disclosure and constitute a part of the specification. Hereinafter, these drawings are intended to explain the technical solution of the disclosure together with the following exemplary embodiments, but should not be considered as a limitation to the technical solution of the disclosure.
Fig. 1 is a structural schematic view of a conventional HJT cell.
Fig. 2 is a structural schematic view of the HJT cell according to an exemplary embodiment of the disclosure.

### DETAILED DESCRIPTION

For clarity and better understanding of the objects, technical solution and advantages of the disclosure, exemplary embodiments of the disclosure will now be described in detail in conjunction with the accompanying drawings. It should be noted that the exemplary embodiments of the disclosure and features therein may be combined with each other in any manner as long as they are not contradictory.

### First Exemplary Embodiment

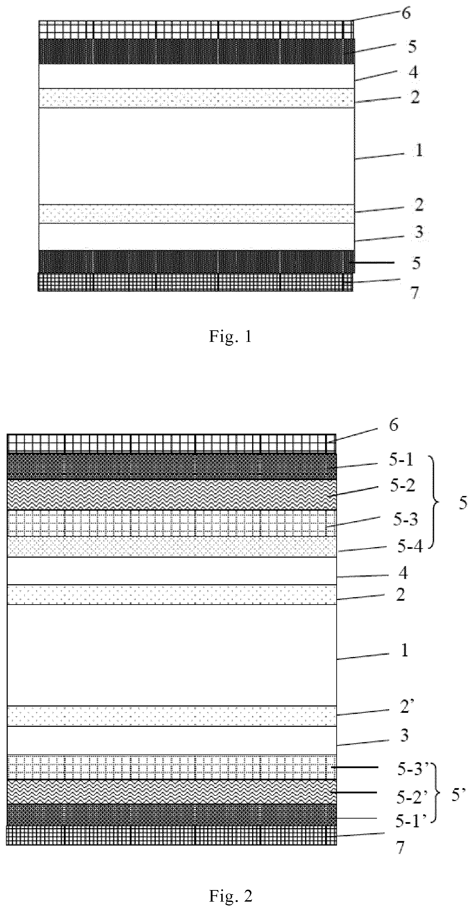

According to one aspect of the disclosure, this exemplary embodiment provides a thin film assembly comprising at least two transparent conductive oxide film layers superposed together, each of the at least two transparent conductive oxide film layers being an ITO film. Specifically, as shown in Fig. 2, a thin film assembly 5 includes four ITO film layers superposed together, which are sequentially a first ITO film layer 5-1, a second ITO film layer 5-2, a third ITO film layer 5-3, and a fourth ITO film layer 5-4; the first ITO film layer 5-1 is doped with a tin content of 10 wt% and has a thickness of 34 nm; obviously, the tin content doped in the first ITO film layer 5-1 may be any value in the range of 10-15 wt%; the second ITO film layer 5-2 is doped with a tin content of 5 wt% and has a thickness of 34 nm; obviously, the tin content doped in the second ITO film layer 5-2 may be any value in the range ≥ 5 wt% and < 10 wt.%; the third ITO film layer 5-3 is doped with a tin content of 3 wt% and has a thickness of 34 nm; obviously, the tin content doped in the third ITO film layer 5-3 may be any value in the range ≥ 1 wt% and < 5 wt.%; the fourth ITO film layer 5-4 is doped with a tin content of 10 wt% and has a thickness of 10 nm; obviously, the tin content doped in the fourth ITO film layer 5-4 may be any value in the range of 10-15 wt%. In addition, those skilled in the art shall understand that the thickness of each of the above ITO film layers is not limited to the listed value, but may be any value in the range of 15-50 nm.

The thin film assembly 5 is prepared according to the following method:
(1) selecting a substrate (a crystalline silicon 1 deposited with two intrinsic layers 2, 2' and two doping layers 3, 4);
(2) adjusting a vacuum degree of a vacuum chamber to be 5 × 10-4Pa, introducing oxygen and argon into the vacuum chamber with a volumetric flow rate ratio of 2:98 and a sputtering power of 4kW, and depositing the fourth ITO film layer 5-4 on the first surface of the substrate by magnetron sputtering;
(3) maintaining the vacuum degree of the vacuum chamber at 5 × 10-4Pa, introducing oxygen and argon into the vacuum chamber with a volumetric flow rate ratio of 5:95 and a sputtering power of 4kW, and continuing to deposit the third ITO film layer 5-3 in the vacuum chamber;
(4) maintaining the vacuum degree of the vacuum chamber at 5 × 10-4Pa, introducing oxygen and argon into the vacuum chamber with a volumetric flow rate ratio of 6:94 and a sputtering power of 4kW, and continuing to deposit the second ITO film layer 5-2 in the vacuum chamber;
(5) maintaining the vacuum degree of the vacuum chamber at 5 × 10-4Pa, introducing oxygen and argon into the vacuum chamber with a volumetric flow rate ratio of 2:98 and a sputtering power of 4kW, and continuing to deposit the first ITO film layer 5-1 in the vacuum chamber.

It should be noted that the vacuum chamber is not opened throughout the deposition process, and the deposition is conducted continuously without breaking vacuum. In other words, the plurality of ITO film layers are prepared continuously under vacuum. In addition, each of the ITO film layers is set to have a refractive index n in a range of 1.8-2.0, a band gap in a range of 3.0-4.6 eV, a carrier concentration in a range of (1-10) × 10²⁰ cm⁻³, and a carrier mobility in a range of 10-50 cm²/vs.

Those skilled in the art shall understand that in the above preparation process, the listed values of the volumetric flow rate ratio of the oxygen to the argon, the sputtering power and the vacuum degree are not limited thereto, but may be selected properly as needed. For example, the volumetric flow rate ratio of the oxygen to the argon may be any value within the range of 0-2:98, the sputtering power may be any value within the range of 2-8kW, and a base pressure of the chamber used in the preparation may be controlled in the range of ≥ 5 × 10-4 Pa.

In the thin film assembly including a plurality of ITO film layers provided in the exemplary embodiment of the disclosure, a multi-layer stepped ITO antireflective film are formed by gradually changing the tin content doped in each of the ITO film layers, thus improving photoelectric properties of the thin film assembly. Compared with a single-layer ITO film, an advantage of the multi-layer stepped ITO film of the present disclosure is further reducing light loss through the multi-layer stepped ITO structure.

### Second Exemplary Embodiment

According to another aspect of the disclosure, as shown in Fig. 2, a thin film assembly 5' provided in this exemplary embodiment includes three ITO film layers superposed together, which are sequentially a first ITO film layer 5-1', a second ITO film layer 5-2', and a third ITO film layer 5-3', the first ITO film layer 5-1' is doped with a tin content of 10 wt% and has a thickness of 37 nm; the second ITO film layer 5-2' is doped with a tin content of 5 wt% and has a thickness of 37 nm; and the third ITO film layer 5-3' is doped with a tin content of 3 wt% and has a thickness of 37 nm.

Then, the third ITO film layer 5-3', the second ITO film layer 5-2', and the first ITO film layer 5-1' of the thin film assembly 5' are deposited on the second surface of the substrate in the first exemplary embodiment according to the steps (3)-(5) for preparing the thin film assembly 5 in the first exemplary embodiment.

Those skilled in the art shall understand that other than the above differences, the thin film assembly 5' in this exemplary embodiment is the same as the thin film assembly 5 in the first exemplary embodiment in structure, parameters and preparing method.

### Third Exemplary Embodiment

As shown in Fig.1, a basic structure of an HJT cell includes: a crystalline silicon layer 1, an intrinsic layer 2, a p-type doping layer 3, an n-type doping layer 4, a transparent conductive oxide film layer 5, a front grid line 6, and a back grid line 7. The transparent conductive oxide film layer 5 in such HJT cells is generally a single-layer film, which cannot fully satisfy the antireflective requirements of light for HJT cells within a greater wavelength range and at greater incident angles.

To this end, the applicant proposes a novel HJT cell with a structure as shown in Fig. 2, i.e., the HJT cell includes an n-type crystalline silicon layer 1 having a first surface and a second surface facing away from each other, intrinsic layers 2 and 2', a p-type doping layer 3, an n-type doping layer 4, the thin film assembly 5 as discussed in the first exemplary embodiment, the thin film assembly 5' as discussed in the second exemplary embodiment, a front grid line 6 and a back grid line 7. Those skilled in the art shall understand that the crystalline silicon layer 1 may also be a p-type crystalline silicon layer.

In the exemplary embodiment of the disclosure, a side where the n-type doping layer 4 is located is defined as a front side of the HJT cell, while a side where the p-type doping layer 3 is located is defined as a back side of the HJT cell.

The intrinsic layer 2, the n-type doping layer 4, the fourth ITO film layer 5-4, the third ITO film layer 5-3, the second ITO film layer 5-2 and the first ITO film layer 5-1 of the thin film assembly 5 of the first exemplary embodiment, and the front grid line 6 are provided on the first surface of the crystalline silicon layer 1 from inside to outside sequentially.

The intrinsic layer 2', the p-type doping layer 3, the third ITO film layer 5-3', the second ITO film layer 5-2' and the first ITO film layer 5-1' of the thin film assembly 5' of the second exemplary embodiment, and the back grid line 7 are provided on the second surface of the crystalline silicon layer 1 from inside to outside sequentially.

With such structure, both sides of the HJT cell may be used for generating electricity, i.e., the HJT cell in this exemplary embodiment is a bifacial power generation cell.

In the exemplary embodiment of the disclosure, a work function of the third ITO film layer 5-3' in contact with the p-type doping layer 3 is greater than a work function of the fourth layer ITO film layer 5-4 in contact with the n-type doping layer 4. Such prepared HJT cell will have increased short-circuit current density and open circuit voltage, thereby effectively improving the conversion efficiency of the cell.

Further, for specific structures of the thin film assemblies 5 and 5', please refer to the first and second exemplary embodiments.

In the HJT cell provided in the exemplary embodiment of the disclosure, a multi-layer stepped ITO antireflective film are formed by gradually changing the tin content doped in each of the ITO film layers, thus improving photoelectric properties of the thin film assembly. Compared with a single-layer ITO film, an advantage of the multi-layer stepped ITO antireflective film of the present disclosure is further reducing light loss through the multi-layer stepped ITO structure, and at the same time, by optimizing the work function matching between the ITO film and the p-type and n-type doping layers, enabling the ITO in contact with the n-type doping layer a lower work function and the ITO in contact with the p-type doping layer a higher work function, thereby improving various performance indicators of the HJT cell.

### Fourth Exemplary Embodiment

According to another aspect of the disclosure, this exemplary embodiment provides a HJT cell which differs from the HJT cell of the third exemplary embodiment in that:
the thin film assembly 5 does not have the third ITO film layer 5-3; the thin film assembly 5' does not have the third ITO film layer 5-3'.

The HJT cell of this exemplary embodiment may obtain similar technical effects as the HJT cell of the third exemplary embodiment.

It should be understood that the above embodiments are merely exemplary embodiments for the purpose of illustrating the principle of the inventive disclosure, and the inventive disclosure is not limited thereto. Various modifications and improvements can be made by a person having ordinary skill in the art without departing from the spirit and essence of the inventive disclosure. Accordingly, all of the modifications and improvements also fall into the protection scope of the inventive disclosure.

## Claims

1. A thin film assembly (5,5') comprising at least two transparent conductive oxide film layers superposed together, each of the at least two transparent conductive oxide film layers being an ITO film, wherein the first ITO film layer (5-1,5-1') is doped with a tin content of 10-15 wt%, and the second ITO film layer (5-2,5-2') is doped with a tin content ≥ 5 wt% and <10 wt%.

2. The thin film assembly (5,5') according to claim 1, further comprising a third ITO film layer (5-3,5-3') doped with a tin content ≥ 1 wt% and <5 wt%, or of 10-15 wt%, the first, second and third ITO film layers (5-1,5-1',5-2,5-2', 5-3,5-3') being arranged sequentially.

3. The thin film assembly (5,5') according to claim 2, wherein the first ITO film layer (5-1,5-1') is doped with a tin content of 10 wt%, the second ITO film layer (5-2,5-2') is doped with a tin content of 5 wt%, and the third ITO film layer (5-3,5-3') is doped with a tin content of 3 wt%.

4. The thin film assembly (5,5') according to claim 2, further comprising a fourth ITO film layer (5-4) doped with a tin content of 10-15 wt%, the first, second, third and fourth ITO film layers (5-1,5-1',5-2,5-2',5-3,5-3',5-4) being arranged sequentially.

5. The thin film assembly (5,5') according to claim 4, wherein the first ITO film layer (5-1,5-1') is doped with a tin content of 10 wt%, the second ITO film layer (5-2,5-2') is doped with a tin content of 5 wt%, the third ITO film layer (5-3,5-3') is doped with a tin content of 3 wt%., and the fourth ITO film layer (5-4) is doped with a tin content of 10 wt%.

6. The thin film assembly (5,5') according to any one of claims 1-5, wherein each of the ITO film layers has a thickness in a range of 10-50 nm.

7. The thin film assembly (5,5') according to any one of claims 1-6, wherein each of the ITO film layers has a refractive index n in a range of 1.8-2.0, a band gap in a range of 3.0-4.6 eV, a carrier concentration in a range of (1-10) × 10²⁰ cm⁻³, and a carrier mobility in a range of 10-50 cm²/vs.

8. A method of preparing the thin film assembly (5,5') according to any one of claims 1-7, comprising: preparing a plurality of ITO film layers continuously under vacuum.

9. The method according to claim 8, wherein the step of preparing a plurality of ITO film layers continuously under vacuum comprises: preparing a plurality of ITO film layers continuously under vacuum by magnetron sputtering, wherein a gas used in the magnetron sputtering is a mixture of oxygen and argon, a volumetric flow rate ratio of the oxygen to the argon is 0-2:98, a sputtering power is 2-8kW, and a base pressure in a chamber used in the preparation is controlled in a range of ≥ 5 × 10⁻⁴ Pa.

10. A hetero-junction cell comprising the thin film assembly (5,5') according to any one of claims 1-7.

11. The hetero-junction cell according to claim 10, wherein the hetero-junction cell comprises a first thin film assembly (5) composed of at least three ITO film layers superposed together at one side thereof and a second thin film assembly (5') composed of at least two ITO film layers superposed together at the other side thereof.

12. The hetero-junction cell according to claim 11, wherein the hetero-junction cell further comprises a crystalline silicon layer (1) having a first surface and a second surface facing away from each other, a first intrinsic layer (2), a second intrinsic layer (2'), a first doping layer (4), a second doping layer (3), a first grid line (6) and a second grid line (7);
the first thin film assembly (5) is provided with four ITO film layers, and the second thin film assembly (5') is provide with three ITO film layers;
the first intrinsic layer (2), the first doping layer (4), a fourth ITO film layer (5-4), a third ITO film layer (5-3), a second ITO film layer (5-2) and a first ITO film layer (5-1) of the first thin film assembly (5), and the first grid line (6) are provided on the first surface of the crystalline silicon layer (1) from inside to outside sequentially;
the second intrinsic layer (2'), the second doping layer (3), a third ITO film layer (5-3'), a second ITO film layer (5-2') and a first ITO film layer (5-1') of the second thin film assembly (5'), and the second grid line (7) are provided on the second surface of the crystalline silicon layer (1) from inside to outside sequentially.

13. The hetero-junction cell according to claim 12, wherein the first ITO film layer (5-1) of the first thin film assembly (5) is doped with a tin content of 10 wt%, the second ITO film layer (5-2) of the first thin film assembly (5) is doped with a tin content of 5 wt%, the third ITO film layer (5-3) of the first thin film assembly (5) is doped with a tin content of 3 wt%, and the fourth ITO film layer (5-4) of the first thin film assembly (5) is doped with a tin content of 10 wt%; and
the first ITO film layer (5-1') of the second thin film assembly (5') is doped with a tin content of 10 wt%, the second ITO film layer (5-2') of the second thin film assembly (5') is doped with a tin content of 5 wt%, and the third ITO film layer (5-3') of the second thin film assembly (5') is doped with a tin content of 3 wt%.

14. The hetero-junction cell according to claim 12 or 13, wherein the crystalline silicon layer (1) is an n-type crystalline silicon layer or a p-type crystalline silicon layer; and
the first doping layer (4) is an n-type doping layer, while the second doping layer (3) is a p-type doping layer.

15. The hetero-junction cell according to claim 14, wherein a work function of the third ITO film layer (5-3') of the second thin film assembly (5') in contact with the second doping layer (3) is greater than a work function of the fourth layer ITO film layer (5-4) of the first thin film assembly (5) in contact with the first doping layer (4).
